# EUROPEAN PATENT SPECIFICATION

(11) **EP 0 447 096 B1**
(45) Date of publication and mention of the grant of the patent: **06.12.1995**
(21) Application number: 91301801.6
(22) Date of filing: 05.03.1991
(51) Int. Cl.: H01S 3/19, H04B 10/12

(54) **Quantum-well laser comprising an InGaAsP containment layer, and method of producing the laser**
Quantenstruktur-Laser mit einer InGaAsP-Begrenzungsschicht und Verfahren zur Herstellung des Lasers
Laser à puits quantiques avec une couche de confinement en InGaAsP et méthode de production de ce laser

(30) Priority: 13.03.1990 US 492143
(43) Date of publication of application: 18.09.1991
(73) Proprietor: AT&T Corp., New York, NY 10013-2412 (US)
(72) Inventor: Logan, Ralph Andre, Morristown, New Jersey 07960 (US); Tanbun-Ek, Tawee, Summit, New Jersey 07901 (US); Temkin, Henryk, Berkeley Heights, New Jersey 07922 (US)
(74) Representative: Watts, Christopher Malcolm Kelway, Dr.

(56) References cited:
- GB-A- 2 131 610
- IEEE PHOTONICS TECHNOLOGY LETTERS, vol. 2, no. 1, January 1990,New York,US; pages 43 - 45; M.SHIMIZU et al.: "Concentration effect on optical amplification characteristics of Er-doped Silica single-mode fibers"'
- ELECTRONICS LETTERS, vol. 25, no. 24, 23 November 1989, Stevenage, Herts, GB; pages 1635 - 1637; D.M. COOPER et al.: "High-power 1.5 mum all-MOVPE buried heterostructure graded index separate confinement multiple quantum well lasers"
- ELECTRONICS LETTERS, vol. 25, no. 9, 27 April 1987,Stevenage, Herts, GB; pages 578 - 580; J.N. TOTHILL et al.: "Novel strained quantum well laser grown by MOVPE."
- APPLIED PHYSICS LETTERS, vol. 49, no. 24, 15 December 1986, New York,US;pages 1659 - 1660; D. FETEKA et al.: "Graded-index separate confinement InGaAs/GaAs strained-layer quantum well laser grown by metalorganic chemical vapor deposition"
- IEEE JOURNAL OF QUANTUM ELECTRONICS, vol. 26, no. 8, August 1990,New York,US;pages 1323 - 1327; T.TANBUN-EK et al: "Growth and characterization of continuously graded index separate confinement heterostructure (GRIN-SCH) InGaAs-InP long wavelength strained layer quantum-well lasers by metalorganic vaporphase epitaxy"

## Description

### Field of the Invention

This invention pertains to the field of semiconductor lasers.

### Background of the Invention

As is well known, imperfections or defects (e.g., dislocations, point defects associated with local areas of non-stoichiometry or foreign inclusions) that are present in semiconductor lasers typically have the greatest effect on laser characteristics if the laser is operated at high power level. Among such possible effects are such highly deleterious ones as rapid deterioration of the laser, output power saturation caused by leakage paths, and inhomogeneity of the distribution of the output envelope of the radiation. Thus it is imperative that high power semiconductor lasers, including quantum well lasers, be free of imperfections and defects to the greatest degree possible.

Quantum well lasers are considered to have many advantages over conventional double heterostructure lasers. These advantages include improved high frequency response, narrower linewidths, higher output power, reduced chirp under modulation, lower threshold current densities, and increased temperature coefficient Tₒ. These advantages have been demonstrated in the GaAs/AlGaAs system.

An advantageous GaAs-based quantum well laser that comprises a graded index separate confinement heterostructure has been reported. See D. Feketa et al., Applied Physics Letters, Vol. 49(24), pages 1659-60. This reference discloses GaAs-based strained layer quantum well lasers, grown by MOCVD, wherein the 4 nm thick Ga_{0.63}In_{0.37}As quantum well is situated between two 0.2 »m thick AlₓGa₁₋ₓAs regions having continuously graded refractive index, wherein x varies continuously and linearly from 0 to 40%. The devices apparently have powers up to about 30 mW/facet, and emitted at a wavelength of about 1 »m.

As those skilled in the art know, the AlGaAs system has the property that essentially any composition within the system is lattice matched with any other composition within the system. Due to this special property of the AlGaAs system, it is relatively easy to produce a continuously graded index region of the type present in the Feketa et al. lasers.

R. M. Ash, et al., Electronics Letters, Vol.25(22) pp. 1530-1531(1988) disclose In P-based graded index separate confinement heterostructure quantum well (GRIN-SCH QW) lasers with continuously graded confinement layers of composition Al_{y}Ga_{0.48-y}In_{0.52}As, with y varying linearly from 0.35 to 0.25. The GaAlInAs system resembles the AlGaAs system in that in the former the concentration in the growth atmosphere of only the group III species need to be varied. However, other quaternary semiconductor systems do not have this property. The InGaAsP is exemplary of these systems.

On the other hand, the InGaAsP system has pronounced advantages over the InGaAlAs system that would make it highly desirable to be able to use the former in GRIN-SCH QW lasers. In particular, the presence of Al, a strong oxygen getter, makes such highly sensitive and complex devices as GRIN-SCH QW lasers relatively difficult to manufacture, since it requires the vigorous elimination of all sources of oxygen in the growth chamber. Under manufacturing conditions this is a difficult task, as those skilled in the art well know, making GRIN-SCH QW lasers that do not comprise Al-containing semiconductor material preferable to such lasers that comprise such material.

Due at least in part to the above referred to complication in the InGaAsP system, it is generally believed by those skilled in the art that continuously graded index regions are not feasible in this system (and in other multiconstituent systems wherein the lattice constant depends on the composition).

In order to obtain emission wavelengths above about 1.2 »m in InGaAs-based QW lasers, the quantum wells would have to be very thin (e.g., about 2-3 nm). Such thin wells are difficult to make. Furthermore, laser performance might be hampered by the resulting difficulties in the carrier capture process. On the other hand, these relatively long wavelengths are of special interest for optical fiber communication. Of particular recent interest are wavelengths at or near about 1.3 »m or 1.5 »m. For instance, radiation at or near 1.48 »m can serve as pump radiation in a 1.55 »m optical fiber communication system that comprises an Er-doped fiber optical amplifier. To be suitable as a source of such pump radiation a laser should have relatively high output power, since the gain that can be obtained in a given fiber optical amplifier increases with increasing pump power. Exemplarily, such a laser should be capable of providing output power of at least 10 mW/facet, preferably more than 25 or even 50 mW/facet. A. Kasukawa et al., Japanese Journal of Applied Physics, Vol. 28(4), pp. L661-L663, Electronics Letters, Vol. 25(2), pp. 104-105, and Electronics Letters, Vol. 25(10), pp. 659-661 disclose 1.3 »m and 1.5 »m InP-based quantum well lasers that comprise two step-wise graded GaInAsP confinement layers. Although the lasers were reported to have been operated at quite high powers, the prior art devices contain features that potentially can result in defects, and thus could reduce yield and/or lead to decreased lifetime. In particular, the presence of step-wise composition changes in the confinement layers can lead to these and other deleterious results. This is due at least in part to the fact that stepwise compositional change requires the growth of separate layers, and during the pause between layers (when source compositions are changed) it is difficult to prevent defect formation at the interface.

See also J. N. Tothill et al., *Electronics Letters*, Vol. 25(9), pp. 578-580, which discloses a quantum well laser that emits at about 1.54»m and comprises GaInAsP waveguide layers of uniform composition. UK Patent Application GB-A-2 131 610 discloses a quantum well laser that comprises a multi-layer waveguide region, each layer being less than 0.003»m thick, the layers alternating in composition between InP and InGaAsP (λ_{g} = 1.55»m). The latter also discloses that very complex control would be needed for the growth of a continuously varying, lattice matched guide layer.

In view of the potential importance of high power, long wavelength quantum well lasers for, e.g., optical amplification in appropriately doped fibers, it would be highly desirable to have available a quantum well laser that emits in the wavelength range above about 1.2 »m (e.g., at a wavelength that is suitable for pumping of a fiber optical amplifier), that can be readily manufactured and that can be operated at relatively high power levels. As was discussed above, high power operation requires that the laser be relatively free of imperfections and defects. Such a desirable laser therefore would comprise design features that tend to reduce the incidence of imperfections and defects. This application discloses such a laser.

### Definition and Glossary of Terms

By "CW emission" we mean herein emission that has relatively constant amplitude over periods of time that are sufficient to permit substantial establishment of thermal equilibrium of the laser.

The "critical thickness x_{c}" herein is that thickness of a given strained semiconductor layer above which strain-relieving dislocations generally appear. The critical thickness depends, inter alia, on the composition of the given layer as well as on the compositions of the adjoining layer or layers, and can be determined theoretically or experimentally. See, for instance, H. Temkin, et al., Applied Physics Letters, Vol. 55(16), pp. 1668-1670.

### Summary of the Invention

The invention is as defined by the claims. In a broad aspect the invention is a method of making a semiconductor quantum well laser having an emission wavelength in the range 1.2-1.68»m and being capable of room temperature CW emission, wherein the laser comprises a confinement layer (typically two confinement layers, with one or more quantum wells between them), that comprises GaInAsP, with the composition of at least a significant portion of the material of the confinement layer varying continuously through the thickness of the portion, with the compositional variation adjusted such that the portion is substantially lattice matched. By "substantially lattice matched "we mean herein that Δa/a ≦3x10⁻⁴, where a is the lattice constant of the material to which the confinement layer is lattice matched, and Δa is the maximum deviation of the lattice constant in the "lattice matched" portion of the confinement layer from a. Typically, the composition of both confinement layers varies continuously, with the material of the confinement layer being single crystal InGaAsP.

Exemplarily, the confinement layer comprises a multiplicity of sublayers, with the composition of a given sublayer varying essentially linearly with distance from an appropriate interface. In currently preferred embodiments, the thickness is selected to be less than the critical thickness for defect formation. This however is an optional added precaution that may not be required in many cases.

Whereas the confinement layers in devices according to the invention are substantially lattice matched and thus are not intentionally strained, the quantum well (or wells) and, where applicable, the barrier layers between the wells, in these devices may be, but need not be, strained. In fact, in some currently preferred embodiments the quantum well composition is such that the wells are strained, with the well thickness and composition selected such that the well thickness is below the critical thickness for the given lattice mismatch. Desirably, the composition of the barrier layers between the quantum wells is selected such that the strain in the former is the opposite of that in the latter (e.g., compressive vs. tensile), such that the overall strain in the region between the confinement layers is kept to a low value.

As is known, the band gap and optical properties of a quantum well can be varied by means of lattice strain. Thus, by appropriate choice of lattice mismatch the range of the well thickness-laser wavelength dependence can be extended to permit easy tailoring of the laser wavelength through choice of growth parameters.

As discussed above, a significant aspect of lasers according to the invention in the presence therein of a continuously graded, substantially lattice watched, InGaAsP confinement layer. Even though this feature causes inventive lasers to be well adapted for high power operation, inventive lasers need not necessarily be high power (i.e., more than 10, 25, or even 50 mW output power) lasers.

Apparatus according to the invention exemplarily is an optical fiber communication system that comprises a length of rare earth (e.g., Er)-doped optical fiber, a laser according to the invention that comprises means for causing an electrical current to flow through the laser such that the laser has output radiation in the wavelength range 1.2-1.68 (e.g., 1.48) »m, and means for coupling at least a part of the output radiation into the rare earth-doped fiber. The apparatus of course also comprises such conventional members as a source of signal radiation, means for coupling the signal radiation into an optical fiber link that comprises the length of rare earth-doped optical fiber, and means for detecting the signal radiation that was transmitted through the fiber link.

Described is also a method of making a laser of the type described above. The method comprises providing a III-V semiconductor body having a major surface, and exposing the major surface to an atmosphere that comprises a multiplicity of molecular species (comprising a first and a second species) such that a confinement layer is formed. The step of forming the confinement layer comprises changing, during at least a part of the formation time of the confinement layer, the concentration of the first species and second species. The respective rates of change are selected such that the composition of the resulting multiconstituent semiconductor material varies continuously with distance from an appropriate interface, e.g., the major surface, with the lattice constant of the resulting material being substantially constant.

### Brief Description of the Drawings

FIG. 1 schematically shows the layer sequence in an exemplary laser according to the invention;
FIG. 2 shows exemplary data on gas precursor flow conditions for growth of InGaAsP that is lattice watched to InP;
FIG. 3 gives data on the Ga content of an exemplary continuously graded InGaAsP layer;
FIGS. 4 and 5 show exemplary data on, respectively, the In content of InGaAsP and the growth rate of InGaAsP; as a function of TMIn flow rate;
FIG. 6 gives an exemplary theoretical curve on the relationship between quantum well composition and width required to achieve a particular laser wavelength; and
FIG. 7 schematically depicts exemplary apparatus according to the invention.

### Detailed Description of Some Preferred Embodiments

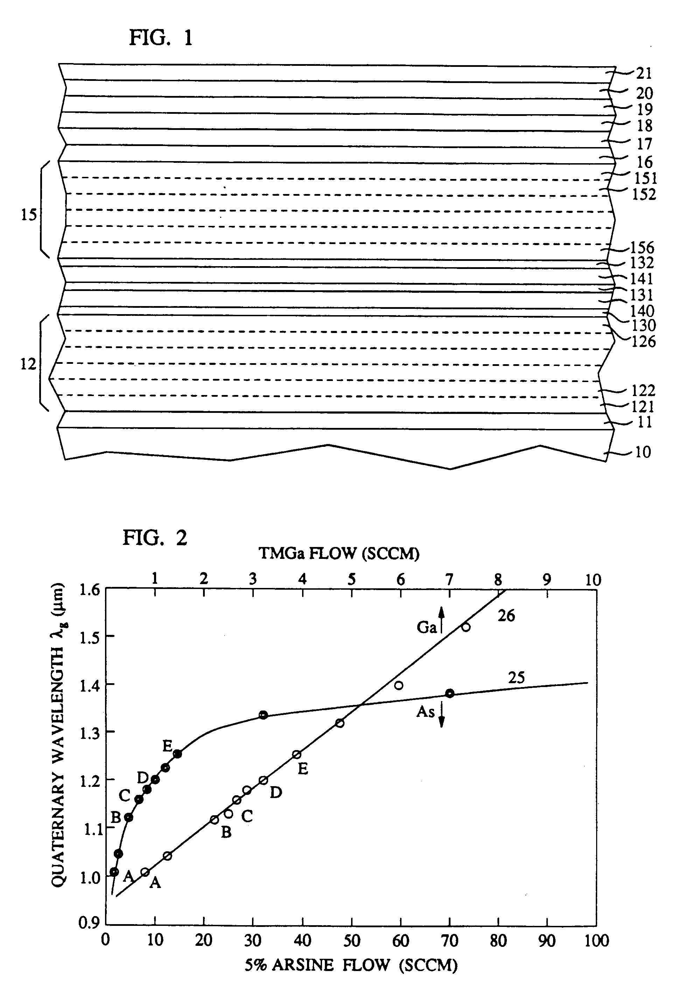

FIG. 1 schematically shows the layer sequence in an exemplary preferred embodiment of the invention, namely, an InP-based strained layer quantum well laser. Substrate 10 is S-doped (n∼10¹⁸/cm³) 100-oriented InP, as is 1 »m thick epitaxial layer 11. Lower confinement layer 12 consists of continuously graded InGaAsP and comprises 6 sublayers 121-126, each sublayer being about 40nm thick. Sublayer 121 at the interface with 11 has a composition having a bandgap corresponding to λ_{g} = 0.99 »m (compositions in this quaternary system are frequently identified by a corresponding bandgap wavelength. This notation is unambiguous and well understood by those skilled in the art), with its composition being linearly graded to result in composition corresponding to λ_{g} = 1.04 »m at the interface with sublayer 122. The compositions of all other sublayers are similarly linearly graded, with the compositions at the other interfaces corresponding, respectively, to 1.12 »m, 1.16 »m, 1.206 »m and 1.25 »m (at the interface with quantum well 130). It is to be emphasized that at the interface between any two sublayers there is no change in composition but only a change in the rate of change of composition. In particular, there is a change in the rate of change of both Ga and As content with distance from, e.g., layer 11. Strained quantum wells 130,131, and 132 each are 4.5nm thick In_{0.5}Ga_{0.5}As, with 20nm thick InGaAsP layers 140 and 141 (of composition corresponding to λ_{g} = 1.25 »m) therebetween. Confinement layer 15 is the mirror image of 12, and is followed by 50nm thick undoped (n∼10¹⁶/cm³) InP layer 16,0.2 »m thick Zn-doped (p∼4x10¹⁷/cm³) InP layer 17, 0.9 »m thick Zn-doped (p∼8x10¹⁷/cm³) InP layer 18,0.4»m thick Zn-doped (p∼1.1x10¹⁸/cm³) InP layer 19,0.12 »m Zn-doped (p∼5x10¹⁸/cm³) InGaAsP (composition corresponding to λg = 1.2 »m) layer 20, and by 0.06 »m thick Zn-doped (p∼10¹⁹/cm³ InGaAsP (composition also corresponding to λ_{g} = 1.2 »m) layer 21.

The above-described epitaxial layer structure was grown by atmospheric pressure metal organic vapor phase epitaxy (MOVPE). However, other growth techniques (e.g., low pressure MOVPE, CBE or gas source MBE) can also be used to practice the invention.

The substrate 10 was prepared conventionally, and epitaxial layer 11 was grown thereon by a conventional technique. The growth of the confinement layers was performed at 625°C, with trimethyl indium (TMIn) at 30°C, trimethyl gallium (TMGa) at -15°C, 5% AsH₃ and 20% PH₃ as precursors. After dicing, provision of conventional optical coating, electrical contacts, and heat dissipation means the laser output was measured. Output in excess of 200mW was observed in a laser of structure substantially as described.

FIG. 2 shows exemplary data on the precursor flow conditions necessary to grow InGaAsP layers that are lattice matched to InP, with λ_{g} ranging from 0.9 to 1.40»m. The data assumes that the flow of 70 sccm TMIn and 225 sccm of the 20% PH₃ is kept constant at a rate that results in excess In and P in the growth atmosphere. The figure indicates, for instance, that, in order to obtain material having a composition corresponding to λ_{g} = 1.01»m the TMGa and AsH₃ flow rates are to correspond to points A on curves 26 and 25, respectively. Analogous remarks apply to compositions corresponding to points B, C, D, and E, as well as to all other points on the curves, as those skilled in the art will recognize.

As discussed above, in devices according to the invention the composition of the confinement layer is varied continuously over a considerable range, e.g., from λ_{g} = 0.99»m to λ_{g} = 1.25»m. This could be done by controlling the flow rate of TMGa and AsH₃ so as always to lie on curves 26 and 25, respectively. This however would pose a complex control problem (since curve 25 is highly non-linear) and is typically not necessary. We have found that a piece-wise linear approximation gives perfectly acceptable results.

In order to grow a InGaAsP confinement layer of thickness t whose composition is lattice matched to InP and varies continuously between λ_{g1} and λ_{g2}, the quantity Δλ_{g} = λ_{g2} - λ_{g1} exemplarily is divided into n parts that define the compositions at which the rate of change of TMGa flow and of AsH₃ flow will be changed. Exemplarily, these correspond to points B, C, and D of FIG. 2.

By way of example, if the layer of material on which the InGaAsP confinement layer is to grow has composition λ_{g1} and if n = 6, then the following procedure can be used. By any appropriate means (e.g., using FIG. 2) the TMGa and AsH₃ flow rates corresponding to λ_{g1}, λ_{g2}, and to the 5 intermediate compositions at which the rate of change of the flow rates are to be altered are determined. Since the material growth rate at any given set of flow rates (at a given constant temperature) is known, the time required to grow any given sublayer can be readily determined. The sublayers will frequently be all the same thickness. By determining the difference in TMGa flow rate corresponding to λ_{g1} and that corresponding to λ_{g1} + Δλ_{ga} (the composition at which the rate of change of the flow rates is to be changed for the first time), and dividing the thus determined difference in flow rate by the previously determined time to grow the first sublayer, the appropriate rate of change of TMGa flow rate is determined. By an analogous procedure the appropriate rate of change of AsH₃ is determined. This procedure can be applied in analogous fashion to determine the appropriate rates of change of flow rates for all the other sublayers of the desired InGaAsP confinement layer.

Computer controllable mass flow controllers suitable for use with TMGa and AsH₃ are commercially available, and software to program a computer to change the flow rates in the above-described fashion is routine for those skilled in the art and does not require discussion.

Continuing with the discussion of the exemplary embodiment; after the layer of composition λ_{g1} has reached the desired thickness, the flows of TMGa and AsH₃ are changed, without growth interruption, such that the flows vary at the respective, previously determined new rates. After elapse of the previously determined time, the rate of change of the respective flows are again adjusted without interruption of the growth. This procedure is continued until all the sublayers are completed.

Since the inventive procedure for growth of InGaAsP confinement layers requires only changes in the rate of change of gas flow, the growth of a confinement layer can be continuous, without cessation of growth upon completion of a given sublayer, as necessarily occurs in the growth of prior art step-wise graded InGaAsP confinement layers. This is considered to be a significant aspect of the invention, since defects tend to easily form from the ambient in the absence of growth.

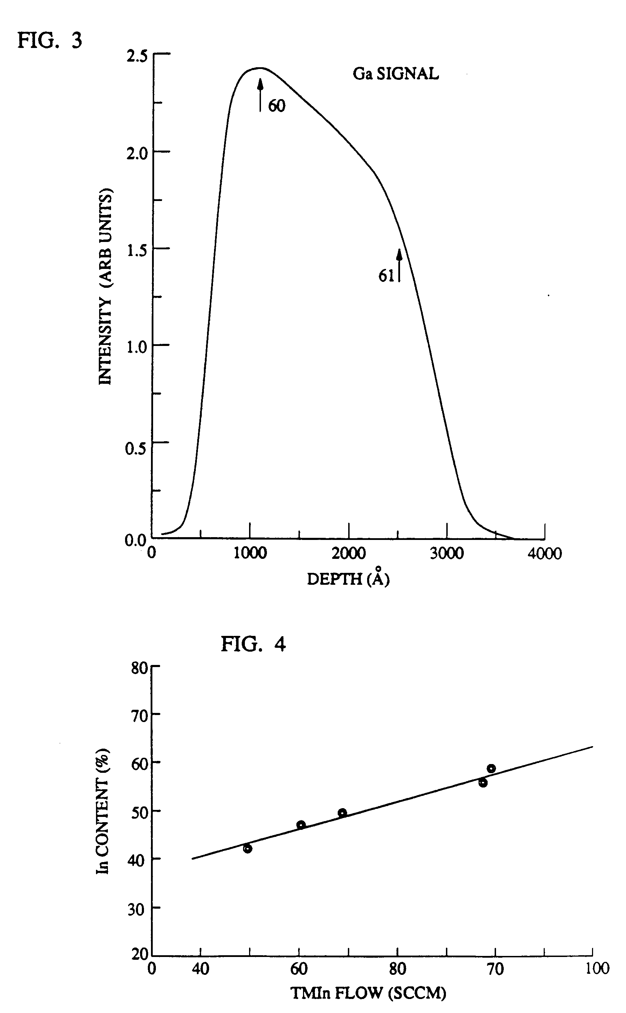

FIG. 3 shows exemplary data on the Ga content of a InₓGa₁₋ₓAs_{y}P_{1-y} continuously graded confinement layer according to the invention, with y∼2.2x in the solid, and λ_{g} varying from 1.1»m at arrow 60 to 1.25»m at arrow 61. As can be seen, the Ga concentration varies continuously (linearly over a major portion of the layer thickness), thereby reducing the likelihood of defect formation.

Upon completion of the growth of the lower confinement layer (e.g. 12 of Fig. 1) typically a quantum well is grown, preferably without (or with minimal) pause in the growth. The quantum well advantageously is InₓGa₁₋ₓAs, with the value of x and the well thickness chosen to yield the desired lasing wavelength. FIG. 4 shows exemplary data on the In content of InGaAs as a function of TMIn flow rate. As can be seen, the dependence is linear, facilitating straightforward adjustment of the solid composition.

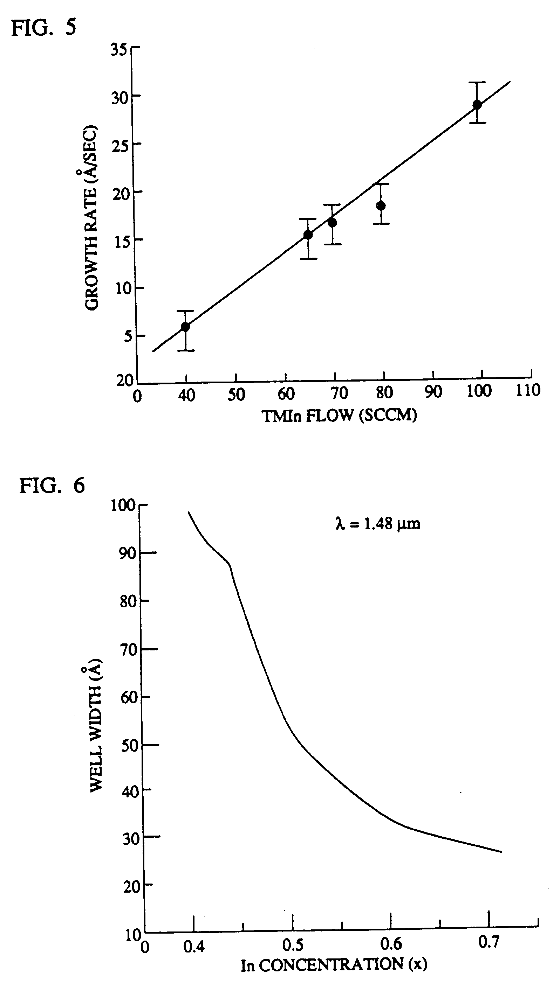

Fig. 5 shows exemplary data on the growth rate of InGaAs as a function of TMIn flow rate (with TMGa and AsH₃ flow fixed at 9 and 160sccm, respectively). The dependence is linear, with the growth rate under the exemplary conditions depending only on the TMIn flow rate.

For at least some applications of lasers according to the invention (e.g., for use as a pumping source of a Er-doped fiber amplifier) it is necessary to finely tune the laser wavelength. This is made possible through adjustment of a degree of strain in the quantum well or wells. FIG. 6 shows an exemplary theoretical curve on the relationship between x (in InₓGa₁₋ₓAs) and the well width needed in order to obtain a lasing wavelength of 1.48»m. Experimental data we have obtained are in good agreement with the theoretical curve, at least for x≧0.43. For x = 0.53 the composition is lattice matched with InP.

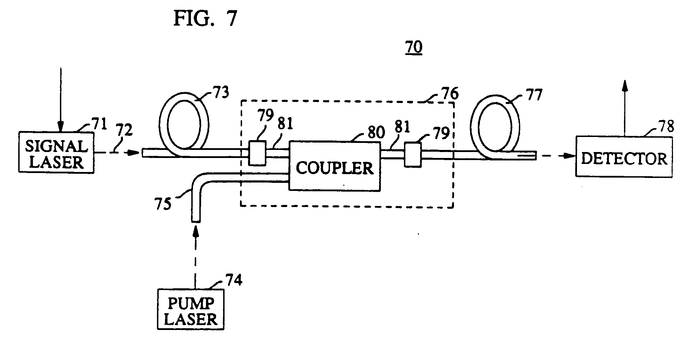

FIG. 7 schematically depicts exemplary apparatus according to the invention, namely, optical fiber communication system 70. Signal laser 71 emits signal radiation 72 which is coupled into standard transmission fiber 73 and transmitted therethrough to fiber amplifier 76. Pump laser 74 emits pump radiation of an appropriate wavelength (e.g., 1.48»m) which is transmitted by means of a short length of fiber 75 into 76. The latter comprises a rare-earth doped fiber 81 coupled signal-transmissively, by means of conventional connectors 79, to 73 and to transmission fiber 77. The amplifier 76 also comprises means 80 to couple the pump radiation from 75 to 81. Such means can be conventional. Signal radiation is amplified in 76 in known manner, and is then transmitted through 77 to detector 78.

## Claims

1. Method of making a semiconductor laser having an emission wavelength in the range 1.2-1.68»m and being capable of room temperature CW emission, the laser comprising;
a) a confinement layer comprising GaInAsP; and
b) an active region comprising one or more quantum wells;
CHARACTERIZED IN THAT
c) formation of the confinement layer consists of growing a multiplicity of InGaAsP sublayers, the composition of each sublayer varying at a different rate as a function of distance from the active region; and in that
d) the growth of the confinement layer is continuous, without cessation of growth upon completion of a given sublayer, such that the composition of the confinement layer varies continuously as a function of distance from the active region, and Δa/a ≦ 3 × 10⁻⁴, where "a" is the lattice constant of the material to which the confinement layer is lattice matched, and Δa is the maximum deviation from "a" of the lattice constant in the lattice matched portion of the confinement layer.

2. Method of claim 1, further comprising forming the active region such that the material of at least one quantum well is strained.

3. Method of claim 2, wherein the active region is formed such that the active region comprises at least two quantum wells with a barrier layer therebetween, wherein the material of the at least two quantum wells is strained, the quantum well strain having a first sense, and wherein furthermore the material of the barrier layer is strained, the barrier layer strain being of a sense opposite to the first sense, whereby the overall strain of the active region is maintained at a relatively low level.

4. Method of claim 1, wherein the laser is formed such that the laser is capable of CW emission at room temperature of at least 50mW of optical power.

5. Apparatus comprising a semiconductor laser having an emission wavelength in the range 1.2-1.68»m and being capable of room temperature CW emission, the laser comprising;
a) a confinement layer comprising GaInAsP; and
b) an active region comprising one or more quantum wells;
CHARACTERIZED IN THAT
c) the confinement layer consists of a multiplicity of InGaAsP sublayers, the composition of each sublayer varying at a different rate as a function of distance from the active region; and in that
d) the composition of the confinement layer varies continuously as a function of distance from the active region, and Δa/a ≦ 3 × 10⁻⁴, where "a" is the lattice constant of the material to which the confinement layer is lattice matched, and Δa is the maximum deviation from "a" of the lattice constant in the lattice matched portion of the confinement layer.

6. Apparatus of claim 5, wherein the material of at least one of the quantum wells is strained.

7. Apparatus of claim 6, wherein the active region comprises at least two quantum wells with a barrier layer therebetween, wherein the material of the at least two quantum wells is strained, the quantum well strain having a first sense, and wherein furthermore the material of the barrier layer is strained, the barrier layer strain being of a sense opposite to the first sense, whereby the overall strain of the active region is maintained at a relatively low level.

8. Apparatus of claim 5, wherein the laser is capable of CW emission at room temperature of at least 50mW of optical power.

9. Apparatus of claim 5, wherein the apparatus is an optical fiber communication system that comprises i) a length of rare earth-doped optical fiber; ii) means for causing an electrical current to flow through the laser such that the laser has an output radiation, the output radiation having a wavelength in the range 1.2-1.68»m; and iii) means for coupling at least a portion of the output radiation into the rare earth-doped optical fiber.

10. Apparatus of claim 6, wherein the rare earth-doped fiber comprises Er.

## Patentansprüche

1. Verfahren zur Herstellung eines Halbleiterlasers mit einer Emissionswellenlänge im Bereich von 1,2 bis 1,68 »m, der bei Raumtemperatur zu Daueremission fähig ist, wobei der Laser umfaßt:
a) eine Einschlußschicht mit GaInAsP,
b) einen aktiven Bereich mit einem oder mehreren Quantenmulden,
dadurch gekennzeichnet, daß
c) die Ausbildung der Einschlußschicht das Aufwachsen einer Vielzahl von InGaAsP-Subschichten umfaßt, wobei sich die Zusammensetzung jeder Subschicht mit einer anderen Rate als Funktion des Abstands vom aktiven Bereich ändert, und
dadurch daß
d) das Aufwachsen der Einschlußschicht kontinuierlich ist, ohne Wegfall des Aufwachsens bei der Vervollständigung einer gegebenen Subschicht, so daß die Zusammensetzung der Einschlußschicht sich kontinuierlich als Funktion des Abstands vom aktiven Bereich ändert, und Δa/a ≦ 3 x 10⁻⁴, wobei "a" die Gitterkonstante des Materials ist, an welche die Einschlußschicht gitterangepaßt ist, und Δa die Maximumabweichung von "a" der Gitterkonstanten im gitterangepaßten Abschnitt der Einschlußschicht ist.

2. Verfahren nach Anspruch 1,
ferner umfassend das Ausbilden des aktiven Bereichs derart, daß das Material wenigstens einer Quantenmulde verspannt ist.

3. Verfahren nach Anspruch 2,
bei welchem der aktive Bereich derart ausgebildet ist, daß der aktive Bereich wenigstens zwei Quantenmulden mit einer Barrierenschicht zwischen diesen umfaßt, wobei das Material der wenigstens zwei Quantenmulden verspannt ist, die Quantenschichtverspannung eine erste Richtung hat und in welcher ferner das Material der Barrierenschicht verspannt ist, wobei die Barrierenschichtverspannung in einer Richtung ist, die der ersten Richtung entgegengesetzt ist, wobei die gesamte Verspannung des aktiven Bereichs bei einem relativ niedrigen Niveau gehalten wird.

4. Verfahren nach Anspruch 1,
bei welchem der Laser derart ausgebildet wird, daß der Laser zu Daueremission bei Raumtemperatur mit wenigstens 50 mW optischer Leistung fähig ist.

5. Vorrichtung umfassend einen Halbleiterlaser mit einer Emissionswellenlänge im Bereich von 1,2 bis 1,68 »m der bei Raumtemperatur zu Daueremission fähig ist,
umfassend:
a) eine Einschlußschicht mit GaInAsP,
b) einen aktiven Bereich mit einer oder mehreren Quantenmulden,
dadurch gekennzeichnet, daß
c) die Einschlußschicht eine Vielzahl von InGaAsP-Subschichten umfaßt, wobei sich die Zusammensetzung jeder Subschicht mit einer anderen Rate als Funktion des Abstands vom aktiven Bereich ändert und
dadurch daß
d) die Zusammensetzung der Einschlußschicht sich kontinuierlich als eine Funktion des Abstands vom aktiven Bereich ändert und Δa/a ≦ 3 x 10⁻⁴ ist, wobei "a" die Gitterkonstante des Materials ist, an welches die Einschlußschicht gitterangepaßt ist, und Δa die Maximumabweichung von "a" der Gitterkonstanten im gitterangepaßten Abschnitt der Einschlußschicht ist.

6. Vorrichtung nach Anspruch 5,
bei welcher das Material von wenigstens einer der Quantenmulden verspannt ist.

7. Vorrichtung nach Anspruch 6,
bei welcher der aktive Bereich wenigstens zwei Quantenmulden mit einer Barrierenschicht zwischen diesen umfaßt, wobei das Material der wenigstens zwei Quantenmulden verspannt ist, die Quantenmuldenverspannung eine erste Richtung hat und wobei ferner das Material der Barrierenschicht verspannt ist, wobei die Barrierenschichtverspannung in einer der ersten Richtung entgegengesetzten Richtung ist, wobei die gesamte Verspannung des aktiven Bereichs bei einem relativ niedrigen Niveau gehalten ist.

8. Vorrichtung nach Anspruch 5,
bei welcher der Laser zu Daueremission bei Raumtemperatur mit wenigstens 50 mW optischer Leistung fähig ist.

9. Vorrichtung nach Anspruch 5,
bei welcher die Vorrichtung ein optisches Faserkommunikationssystem ist, welches umfaßt:
i) einen Abschnitt einer mit Seltenen Erden dotierten optischen Faser,
ii) eine Einrichtung zum Veranlassen des Flusses eines elektrischen Stroms durch den Laser derart, daß der Laser eine Ausgangsstrahlung aufweist, wobei die Ausgangsstrahlung eine Wellenlänge im Bereich von 1,2 bis 1,68 »m hat und
iii) eine Einrichtung zum Koppeln wenigstens eines Teils der Ausgangsstrahlung in die mit Seltenen Erden dotierte optische Faser.

10. Vorrichtung nach Anspruch 6,
bei welcher die mit Seltenen Erden dotierte Faser Er umfaßt.

## Revendications

1. Procédé de fabrication d'un laser à semiconducteurs ayant une longueur d'onde d'émission dans la gamme de 1,2-1,68 »m et qui est capable d'émettre en régime continu à la température ambiante, le laser comprenant :
a) une couche de confinement consistant en GaInAsP; et
b) une région active comprenant un ou plusieurs puits quantiques;
CARACTERISE EN CE QUE
c) la formation de la couche de confinement consiste à faire croître une multiplicité de sous-couches en GaInAsP, la composition de chaque sous-couche variant à une vitesse différente en fonction de la distance à partir de la région active; et en ce que
d) la croissance de la couche de confinement est continue, sans interruption de la croissance au moment de l'achèvement d'une sous-couche donnée, de façon que la composition de la couche de confinement varie continuellement en fonction de la distance à partir de la région active, et Δa/a ≦ 3 x 10⁻⁴, en désignant par "a" la constante de réseau du matériau vis-à-vis duquel la couche de confinement présente la propriété de concordance de réseau cristallin, et par Δa l'écart maximal, par rapport à "a", de la constante de réseau dans la partie de la couche de confinement qui présente la propriété de concordance de réseau cristallin.

2. Procédé selon la revendication 1, comprenant en outre la formation de la région active de façon que le matériau d'au moins un puits quantique soit soumis à une contrainte.

3. Procédé selon la revendication 2, dans lequel la région active est formée de façon que cette région active comprenne au moins deux puits quantiques avec une couche de barrière entre eux, dans lequel le matériau de l'un au moins des deux puits quantiques est soumis à une contrainte, la contrainte du puits quantique ayant un premier sens, et dans lequel, en outre, le matériau de la couche de barrière est soumis à une contrainte, la contrainte de la couche de barrière ayant un sens opposé au premier sens, grâce à quoi la contrainte globale de la région active est maintenue à un niveau relativement bas.

4. Procédé selon la revendication 1, dans lequel le laser est formé d'une manière telle qu'il soit capable d'émettre en régime continu à la température ambiante, à un niveau de puissance optique d'au moins 50 mW.

5. Dispositif comprenant un laser à semiconducteurs ayant une longueur d'onde d'émission dans la gamme de 1,2-1,68 »m, et capable d'émettre en régime continu à la température ambiante, le laser comprenant :
a) une couche de confinement consistant en GaInAsP; et
b) une région active comprenant un ou plusieurs puits quantiques;
CARACTERISE EN CE QUE
c) la couche de confinement consiste en une multiplicité de sous-couches en GaInAsP, la composition de chaque sous-couche variant à une vitesse différente en fonction de la distance à partir de la région active; et en ce que
d) la composition de la couche de confinement varie de manière continue en fonction de la distance à partir de la région active, et Δa/a ≦ 3 x 10⁻⁴, en désignant par "a" la constante de réseau du matériau vis-à-vis duquel la couche de confinement présente la propriété de concordance de réseau cristallin, et par Δa l'écart maximal vis-à-vis de "a" de la constante de réseau dans la partie de la couche de confinement qui présente la propriété de concordance de réseau cristallin.

6. Dispositif selon la revendication 5, dans lequel le matériau de l'un au moins des puits quantiques est soumis à une contrainte.

7. Dispositif selon la revendication 6, dans lequel la région active comprend au moins deux puits quantiques avec une couche de barrière entre eux, dans lequel le matériau de l'un au moins des deux puits quantiques est soumis à une contrainte, la contrainte du puits quantique ayant un premier sens, et dans lequel, en outre, le matériau de la couche de barrière est soumis à une contrainte, la contrainte de la couche de barrière ayant un sens opposé au premier sens , grâce à quoi la contrainte globale de la région active est maintenue à un niveau relativement bas.

8. Dispositif selon la revendication 5, dans lequel le laser est capable d'émettre en régime continu à la température ambiante, à un niveau de puissance optique d'au moins 50 mW.

9. Dispositif selon la revendication 5, consistant en un système de communication par fibre optique qui comprend i) une longueur de fibre optique dopée par une terre rare; ii) des moyens pour faire circuler un courant électrique dans le laser, de façon que le laser ait un rayonnement de sortie, le rayonnement de sortie ayant une longueur d'onde dans la gamme de 1,2-1,68 »m; et iii) des moyens pour coupler au moins une partie du rayonnement de sortie vers la fibre optique dopée par une terre rare.

10. Dispositif selon la revendication 6, dans lequel la fibre optique dopée par une terre rare contient l'élément Er.
